# EUROPEAN PATENT SPECIFICATION

(11) **EP 3 169 464 B1**
(45) Date of publication and mention of the grant of the patent: **13.06.2018**
(21) Application number: 14789354.9
(22) Date of filing: 15.07.2014
(51) Int. Cl.: B22F 1/00, H01L 31/0224, H01L 31/18

(54) **METHOD FOR THE PREPARATION OF A TRANSPARENT AND CONDUCTIVE AUTO-SUPPORTED SILVER NANOWIRE FILM AND APPLICATIONS THEREOF**
VERFAHREN ZUR HERSTELLUNG EINES TRANSPARENTEN UND LEITFÄHIGEN SELBSTGETRAGENEN SILBERNANODRAHTFILMS UND ANWENDUNGEN DAVON
PROCÉDÉ DE PRÉPARATION D'UN FILM DE NANOFILS D'ARGENT AUTO-SUPPORTÉ TRANSPARENT ET CONDUCTEUR ET SES APPLICATIONS

(43) Date of publication of application: 24.05.2017
(73) Proprietor: Centre National de la Recherche Scientifique, 75016 Paris (FR)
(72) Inventor: BACKOV, Rénal, 33200 Bordeaux-Cauderan (FR); POULIN, Philippe, 33400 Talence (FR); IDIER, Jonathan, 33400 Talence (FR)
(74) Representative: Novagraaf Technologies
(86) International application number: PCT/IB2014/001448
(87) International publication number: WO 2016/009242

(56) References cited:
- US-A1- 2014 004 371
- US-A1- 2014 020 737

## Description

The invention generally relates to the field of transparent electrodes. In particular, the invention relates to a method for producing a transparent and conducting auto-supported silver nanowire film, to the transparent and conducting silver nanowire film obtained by said method and to the use of said film as a transparent and flexible electrode in an electric device, in particular in a photovoltaic cell (solar cell).

Transparent electrodes are used in a large range of applications such as plasma screens, liquid crystal displays, touch screens, Organic Light-Emitting Devices (OLEDs), solar cells...

Most of transparent electrodes are currently made of inorganic materials such as indium tin oxide (ITO). However, ITO is brittle, cannot be bent and its process of deposition is very costly. Moreover, indium is getting scarce. That is why alternative solutions, such as films made by liquid deposition of carbon nanotubes or silver nanowires (AgNWs), have been investigated for a few years. Challenges in the field consist in assembling the materials in order to achieve optimized compromises of transparency and sheet-resistance.

Because of their metallic nature, silver nanowires are promising candidates to replace ITO thanks to their high conductivity at room temperature and the possibility to deposit them onto plastic substrates such as Poly(Ethylene Terephtalate) (PET). Their one-dimensional structure plays an important role in these performances as the percolation threshold can be reached for low concentration of materials. However, silver nanowires get oxidized in time when exposed in air and their performances decrease quickly.

Different solutions have already been proposed to prevent oxidation of silver nanowires. For examples, previous works report the use of graphene/AgNWs (Ruiyi Chen et al., Adv. Funct. Mater, 2013, 23, 5150-5158), reduced graphene oxide/AgNWs (Yumi Ahn et al., Appl. Mater. Interfaces, 2012, 4, 6410-6414), polycarbonate/AgNWs composites (Ivan Moreno et al., Nanotechnology, 2013, 24, 275603) or of coating of AgNWs with an oxidation protection layer made from an oxide such as titanium dioxide TiO₂ (US patent application N° 2014/0020737) resulting in an oxidation stability for a few months. Nevertheless, these different solutions are not fully satisfactory since these protective layers tend to reduce the conductivity and transmittance of the electrodes.

It remains therefore critical to find new approaches that allow protection against oxidation silver nanowires when used to prepare transparent conductive films without downgrading electro-optical properties of the corresponding electrodes.

The present invention has thus for first object, a method for producing a transparent and conductive auto-supported silver nanowire film, said method comprising at least the following steps:
1) a first step of preparing a dispersion of silver nanowires in a liquid medium comprising at least one solvent and triphenylphosphine (TPP) or a derivative thereof, said derivative being chosen among Bis(2,4-dimethoxyphenyl)phenylphosphine, (methylphenyl)diphenylphosphine and 1,2-bis(diphenylphosphino)ethane,
2) a second step of depositing the dispersion obtained in step 1) onto a substrate to obtain an assembly comprising a silver nanowire film supported on said substrate,
3) a third step of drying the assembly obtained in step 2) to obtained a dried assembly,
4) a fourth step of separating the silver nanowire film from the substrate of the dried assembly obtained in step 3) to obtain a transparent and conductive auto-supported silver nanowire film.

As it is demonstrated in the example illustrating the present invention, the use of triphenylphosphine (TPP) as a stabilizing agent makes it possible to lead, in a simple and economic manner, to silver nanowires films which are resistant to oxidation and that without altering their intrinsic properties such as transmittance and sheet resistance. In particular, and thanks to its affinity with silver nanowires, TPP molecules form a thin oxidation protection layer and do not interfere with the electrical conductivity along the wires. The resulting silver nanowires films are stable in air more than three months and the sheet resistance does not change during this period (12 Ω/sq. and 75% transmittance). Stability is also demonstrated in highly oxidative medium such as nitric acid atmosphere. The present invention satisfies an important technological demand for the development of new and efficient transparent and flexible electrodes. It is industrially viable since TPP is a low cost material that can be easily combined with silver nanowire to lead easily to transparent and flexible electrodes.

Silver nanowires used according to step 1) of the present method are preferably chosen among those having a mean diameter ranging from 5 to 200 nm (more preferably from 25 to 60 nm) and a length ranging from 1 to 100 µm (more preferably from 10 to 75 µm).

Silver nanowires are commercially available products. It can for example be mentioned those sold under the trade names Silver Nanowire AgNW-25, Silver Nanowire AgNW-60, Silver Nanowire AgNW-115 and Silver Nanowire AgNW-130 by the firm Seashell Technologies.

The liquid medium used to disperse the silver nanowires during step 1) is preferably chosen among water, isopropyl alcohol, ethylene glycol and epoxy resin. According to a preferred embodiment of the invention method, the liquid medium is isopropyl alcohol.

The amount of silver nanowires in the dispersion of step 1) preferably varies from about 0.1 to 4 mg.mL⁻¹, and more preferably from about 0.1 to 1 mg.mL⁻¹.

According to the invention, the expression derivatives of triphenylphosphine encompasses triphenylphosphines which comprise one or more substituents on at least one phenyl ring such substituents being for example chosen among alkyl groups, alkoxy groups, etc... Specifically, those derivatives of triphenylphosphine are Bis(2,4-dimethoxyphenyl)phenylphosphine, (methylphenyl)diphenylphosphine and 1,2-bis(diphenylphosphino)ethane.

The amount of triphenylphosphine in the dispersion of step 1) preferably varies from about 0.05 to 2 mg.mL⁻¹, and more preferably from about 0.11 to 1.1 mg.mL⁻¹.

According to a preferred embodiment of the present method, the weight ratio of silver nanowires to TPP varies from about 2:1 to 1:2, and more preferably from about 1:1 to 1:2.

The first step is preferably carried out under mechanical agitation (stirring).

The deposition of the dispersion obtained at step 1) onto the substrate can be carried out by filtering, spray coating, roll coating, dip coating, printing, transfer stamping, etc, depending on the nature of the substrate.

According to a particulate embodiment of the present method, the substrate is a porous filter and step 2) is carried out by filtering of the dispersion obtained in step 1) onto said porous filter.

In that case, the pores of said porous filter have preferably an average diameter ranging from 0.02 µm to 0.2 µm, and more preferably of 0.2µm. As examples of such a porous filter, it can be mentioned anodized aluminum oxide (AAO) membranes, nylon/polyamide membranes, polytetrafluoroethylene membranes, and mixed cellulose ester membranes. The use of an anodized aluminum oxide (AAO) membrane is preferred according to the invention.

The filtering step is then preferably carried out under vacuum.

The drying of step 3) can be performed by heat treatment of the assembly obtained in step 2) in air, at a temperature preferably ranging from about 60 to 90°C, and for a period of time varying from about 5 to 30 minutes.

The fourth step of separating the silver nanowires film from the substrate can be performed by any method allowing the recovery of the auto-supported silver nanowires film, such as for example peeling the silver nanowire film from the substrate, or dissolving the substrate of the dried assembly obtained in step 3) in a dissolving medium.

According to a particulate embodiment of the present method, and when the substrate used in step 2) is an anodized aluminum oxide filter, step 4) is preferably carried out by immersion of the dried assembly into a liquid medium which is able to dissolve said filter. For example, said liquid medium is an alkalinizing agent such as sodium hydroxide (NaOH) or potassium hydroxide (KOH).

According to this particulate embodiment, the method of the invention further comprises a fifth step of rinsing and drying the auto-supported silver nanowires film. In that case, the rinsing of step 5) is preferably carried out with deionized water until to reach a neutral pH.

The drying of step 5) can be carried out in the same conditions of temperature and time than the drying of step 3) preferably after the auto-supported silver nanowire film has been transferred onto a solid substrate, such as for example onto a poly(ethylene terephtalate) (PET substrate)..

The auto-supported silver nanowires films obtained at the end of the present method can be stored at ambient temperature without any particular precaution.

Another object of the present invention is the transparent and conductive auto-supported silver nanowires film directly obtained by the method disclosed in the first object of the invention, wherein said film comprises a web of percolated silver nanowires, wherein the surface of said nanowires is coated by an oxidation resistant layer comprising triphenylphosphine or a derivative thereof.

The thin films can be characterized by UV-visible measurements (transmittance), by atomic force microscopy (AFM) to evaluate their roughness and thickness, by high-resolution scanning electron microscopy (HR-SEM) to evaluate their morphology, and by four-probe measurements to evaluate their sheet resistance.

The auto-supported silver nanowires films have a thickness preferably ranging from about 10 nm to 300 nm.

The auto-supported silver nanowires films according to the invention can advantageously be used as a transparent and flexible electrode.

Therefore, a third object of the present invention is the use of an auto-supported silver nanowires film directly obtained by the method described in the first object of the present invention or as defined according to the second object of the present invention, as a transparent and flexible electrode in an electric device. In particular the auto-supported silver nanowire film of the invention can be used as a transparent and flexible electrode in a photovoltaic cell (solar cell), in plasma screens, in liquid crystals displays, in touch screens, or in organic light-emitting devices (OLEDs).

A fourth objet of the present invention is therefore an electric device comprising at least one auto-supported silver nanowires film directly obtained by the method described in the first object of the present invention or as defined according to the second object of the present invention, as a transparent and flexible electrode.

Hereinafter, the present invention will be additionally described based on the following examples which are given not limiting in any manner.

### EXAMPLES

The raw materials used in the examples are listed below:
- Silver nanowires (average diameter 26 nm, average length 24 µm) sold under the trade name Silver Nanowire AgNW-25 from Seashell Technologies at a concentration of 5.4 mg.mL⁻¹ in isopropyl alcohol,
- Triphenylphosphine (Aldrich, 99 %)

All other products used in these examples were of analytical grade. These raw materials have been used as received from the manufacturers, without any step of purification, unless otherwise stipulated.

### EXAMPLE 1: Preparation and properties of transparent and conductive silver nanowire films according to the method of the invention

In this example, different silver nanowire transparent and conductive films have been prepared according to the method of the invention, i.e. using triphenylphosphine (TPP) as an agent for preventing oxidation of the silver nanowires (AgNW-TPP films). A comparative silver nanowire transparent and conductive film has also been prepared according to a method not forming part of the present invention, i.e. without using triphenylphosphine as an agent for preventing oxidation of the silver nanowires (AgNW film). They have then been compared with regards to their respective optical properties, sheet resistivity and resistance to accelerated oxidation.

The dispersion of silver nanowires as purchased was then diluted with isopropyl alcohol to obtain a concentration of silver nanowires of 0.054 mg.mL⁻¹. This diluted dispersion of silver nanowires was then used in the overall process.

A triphenylphosphine (Aldrich, 99%) solution at 3.4 mg.mL⁻¹ in isopropyl alcohol was prepared.

Silver nanowires and silver nanowires + triphenylphosphine dispersions were then prepared as follows:
- Dispersion 1: 0.5 mg of Silver nanowires without TPP
- Dispersion 2: 0.5 mg of silver nanowires + 0.55 mg of TPP,
- Dispersion 3: 0.1 mg of silver nanowires without TPP,
- Dispersion 4: 0.1 mg of silver nanowires + 0.11 mg of TPP.

Each of the dispersions was vacuum filtered on an Anodized Aluminium Oxide (AAO) filter (47 mm, 0.02 µm, Whatman).

The resulting film+membrane assembly was then dried during 5 minutes at 60°C in air. The film transfer was carried out by dissolving the alumina membrane with a NaOH solution and deposition of the film onto a PET substrate.

To do so, 20 mL of a 1,5M NaOH solution was prepared and put in a Petri dish. The alumina membrane was firstly put on deionized water to fill the pores with water and drive the dissolution softer. The wet membrane was then put on the NaOH solution and dissolved within 15 minutes. The solution was partially taken out of the Petri dish, as well as the alumina fragments. The solution has been changed several times with deionized water in order to reach a neutral pH.

A 5x5 cm² PET substrate was put at the bottom of the Petri dish. The remaining water was taken out with a pipette, allowing the film to deposit onto the PET membrane. The PET supporting the films was then dried at 60°C in air.

4 films were prepared respectively with Dispersions 1 to 4:
- Film called 0.5AgNW-0TPP not forming part of the present invention, i.e. prepared with Dispersion 1 comprising only silver nanowires and no TPP;
- Film called 0.5AgNW-0.55TPP according to the invention, i.e. prepared with Dispersion 2 comprising both silver nanowires and TPP;
- Film called 0.1AgNW-0TPP not forming part of the present invention, i.e. prepared with Dispersion 3 comprising only silver nanowires and no TPP; and
- Film called 0.1AgNW-0.11TPP according to the invention, i.e. prepared with Dispersion 4 comprising both silver nanowires and TPP.

In these denominations, the numbers correspond to the mass (in mg) of each component used in the dispersion. These films were stored in normal conditions of pressure and temperature

The transmittance and sheet resistivity measurements were tested on films 0.5AgNW-0TPP and 0.5AgNW-0.55TPP.

The transmittance of the films was measured at a wavelength of 550 nm with a Cary 100 Bio UV-vis spectrophotometer.

The sheet resistivity of the films was measured with a four-point probe method as a function of time. Four equidistant gold electrodes are evaporated through a mask all along the substrates prior to carrying out the measurements. An electrical assembly composed of four flexible "conductive fingers" has been used. These "fingers" are put in touch with the gold electrodes. Current is applied to the external electrodes while voltage is measured at the central electrodes (range of current from a few nA to some mA is applied). The use of Ohm's law gives resistance which is converted in sheet resistance by normalizing it with the ratio of the length to the spacing of the electrodes.

For both, measurements have been carried out for 108 days.

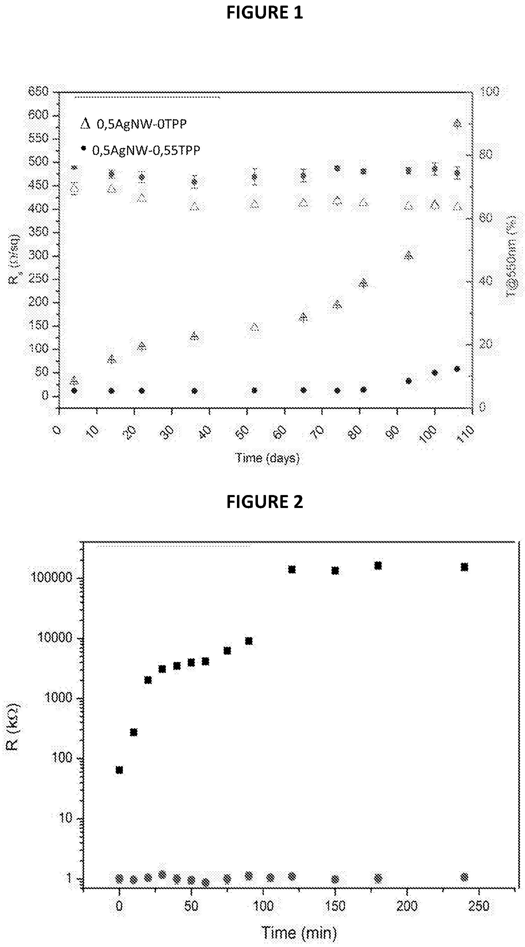

The corresponding results are given by figure 1 annexed on which the sheet resistivity (in Ohms/sq) and transmittance (in %) are expressed as a function of time (in days). On this figure, the two higher curves correspond to transmittance while the two lower curves correspond to sheet resistivity. For each, the triangles correspond to the measurements made on the 0.5AgNW-0TPP film not forming part of the invention while the dark dots correspond to the 0.5AgNW-0.55TPP film according to the invention.

This figure clearly shows an increase of the sheet resistivity when the nanowires are not coated with TPP (0.5AgNW-0TTP film not forming part of the present invention). In addition, it can be concluded that the presence of TPP doesn't affect the transmittance which is comparable for materials with or without TPP, films made of TPP protected nanowires (0.5AgNW-0.55TPP) exhibit a constant resistivity as a function of time.

The resistance to accelerated oxidation was tested on films 0.1AgNW-0TPP and 0.1AgNW-0.11TPP.

The method to test the resistance of the films to accelerated oxidation consists in depositing films on an anodic aluminium oxide (AAO) membranes and then to expose them to nitric acid vapours. Mother solutions of fuming nitric acid in water from 0.001 to 0.1M are prepared. A small amount of the mother solution is placed in a petri Dish at the bottom of a dessicator before putting the films in the latter. Films are taken out of the dessicator to carry out measurements before putting them back in the dessicator. The small amount of nitric acid solution is replaced every time the samples are taken out.

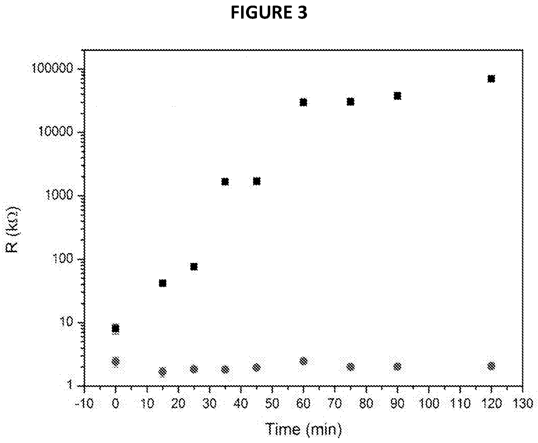

The results are reported in Figures 2 and 3 annexed on which the resistance to accelerated oxidation (in kOhms: kΩ) is given as a function of time (in min). Figure 2 represents the evolution in time of the resistance of the 0.1AgNW-0TPP (dark squares) and 0.1AgNW-0.11TPP (dark dots) films exposed to 0.005 M nitric acid vapours and

Figure 3 represents the evolution in time of the resistance of the 0.1AgNW-0TPP (dark squares) and 0.1AgNW-0.11TPP films (dark dots) exposed to 0.01 M nitric acid vapours.

Figures 2 and 3 clearly show that the 0.1AgNW-0TPP film not forming part of the invention gets oxidized very quickly. Indeed its electrical resistance increases by several orders of magnitude after a few hours (from 10 kΩ to 10⁵ kΩ). By contrast, the resistance of the 0.1AgNW-0.11TPP film according to the present invention remains constant in the same conditions, even after several hours in this highly oxidative medium.

The above detailed results clearly demonstrate the efficacy of the method of the invention at protecting AgNW against oxidation, even in highly oxidative conditions.

## Claims

1. A method for producing a transparent and conductive auto-supported silver nanowire film, said method comprising at least the following steps:
1) a first step of preparing a dispersion of silver nanowires in a liquid medium comprising at least one solvent and triphenylphosphine (TPP) or a derivative thereof, said derivative being chosen among Bis(2,4-dimethoxyphenyl)phenylphosphine, (methylphenyl)diphenylphosphine and 1,2-bis(diphenylphosphino)ethane,
2) a second step of depositing the dispersion obtained in step 1) onto a substrate to obtain an assembly comprising a silver nanowire film supported on said substrate,
3) a third step of drying the assembly obtained in step 2) to obtained a dried assembly,
4) a fourth step of separating the silver nanowire film from the substrate of the dried assembly obtained in step 3) to obtain a transparent and conductive auto-supported silver nanowire film.

2. The method according to claim 1, wherein silver nanowires used according to step 1) are chosen among those having a mean diameter ranging from 5 to 200 nm and a length ranging from 1 to 100 µm.

3. The method according to claim 1 or 2, wherein the liquid medium used to disperse the silver nanowires during step 1) is chosen among water, isopropyl alcohol, ethylene glycol and epoxy resin.

4. The method according to anyone of the preceding claims, wherein the amount of silver nanowires in the dispersion of step 1) varies from 0.1 to 4 mg.mL⁻¹.

5. The method according to anyone of the preceding claims, wherein the amount of triphenylphosphine in the dispersion of step 1) varies from 0.05 to 2 mg.mL⁻¹.

6. The method according to anyone of the preceding claims, wherein the weight ratio of silver nanowires to TPP varies from about 2:1 to 1:2.

7. The method according to anyone of the preceding claims, wherein the substrate is a porous filter and step 2) is carried out by filtering of the dispersion obtained in step 1) onto said porous filter.

8. The method according to claim 7, wherein the porous filter is an anodized aluminum oxide (AAO) membrane.

9. The method according to anyone of the preceding claims, wherein the drying of step 3) is performed by heat treatment of the assembly obtained in step 2) in air, at a temperature ranging from 60 to 90°C, and for a period of time varying from 5 to 30 minutes.

10. The method according to claim 8 or 9, wherein the fourth step of separating the silver nanowires film from the substrate is performed by dissolving the substrate of the dried assembly obtained in step 3) in a dissolving medium.

11. A transparent and conductive auto-supported silver nanowires film directly obtained by the method as claimed in anyone of the preceding claims, wherein said film comprises a web of percolated silver nanowires, and wherein the surface of said nanowires is coated by an oxidation resistant layer comprising triphenylphosphine or a derivative thereof, said derivative being chosen among Bis(2,4-dimethoxyphenyl)phenylphosphine, (methylphenyl)diphenylphosphine and 1,2-bis(diphenylphosphino)ethane.

12. The film of claim 11, wherein said film has a thickness ranging from 10 to 300 nm.

13. Use of an auto-supported silver nanowires film directly obtained by the method of anyone of claims 1 to 10 or as defined in claim 11 or 12, as a transparent and flexible electrode in an electric device.

14. The use of claim 13, wherein said auto-supported silver nanowires film is used as a transparent and flexible electrode in a photovoltaic cell, in plasma screens, in liquid crystals displays, in touch screens, or in organic light-emitting devices.

15. An electric device comprising at least one auto-supported silver nanowires film directly obtained by the method as claimed in anyone of claims 1 to 10 or as defined in claim 11 or 12, as a transparent and flexible electrode.

## Patentansprüche

1. Verfahren zum Herstellen eines transparenten und leitfähigen selbstgeträgerten Silbernanodrahtfilms, wobei das Verfahren mindestens die folgenden Schritte umfasst:
1) einen ersten Schritt des Zubereitens einer Dispersion aus Silbernanodrähten in einem flüssigen Medium, umfassend mindestens ein Lösemittel und Triphenylphosphin (TPP) oder ein Derivat davon, wobei das Derivat unter Bis(2,4-dimethoxyphenyl)phenylphosphin, (Methylphenyl)diphenylphosphin und 1,2-Bis(diphenylphosphino)ethan ausgewählt wird,
2) einen zweiten Schritt des Abscheidens der in Schritt 1) erhaltenen Dispersion auf ein Substrat, um eine Anordnung, umfassend einen auf dem Substrat geträgerten Silbernanodrahtfilm, zu erhalten,
3) einen dritten Schritt des Trocknens der in Schritt 2) erhaltenen Anordnung, um eine getrocknete Anordnung zu erhalten,
4) einen vierten Schritt des Trennens des Silbernanodrahtfilms von dem Substrat der in Schritt 3) erhaltenen getrockneten Anordnung, um einen transparenten und leitfähigen selbstgeträgerten Silbernanodrahtfilm zu erhalten.

2. Verfahren nach Anspruch 1, wobei nach Schritt 1) verwendete Silbernanodrähte unter denjenigen mit einem mittleren Durchmesser im Bereich von 5 bis 200 nm und einer Länge im Bereich von 1 bis 100 µm ausgewählt werden.

3. Verfahren nach Anspruch 1 oder 2, wobei das zum Dispergieren der Silbernanodrähte während Schritt 1) verwendete flüssige Medium ausgewählt wird unter Wasser, Isopropylalkohol, Ethylenglycol und Epoxidharz.

4. Verfahren nach einem der vorstehenden Ansprüche, wobei die Menge an Silbernanodrähten in der Dispersion aus Schritt 1) von 0,1 bis 4 mg.mL⁻¹ variiert.

5. Verfahren nach einem der vorstehenden Ansprüche, wobei die Menge an Triphenylphosphin in der Dispersion aus Schritt 1) von 0,05 bis 2 mg.mL⁻¹ variiert.

6. Verfahren nach einem der vorstehenden Ansprüche, wobei das Gewichtsverhältnis von Silbernanodrähten zu TPP von etwa 2 : 1 bis 1 : 2 variiert.

7. Verfahren nach einem der vorstehenden Ansprüche, wobei das Substrat ein poröser Filter ist und Schritt 2) durch Filtern der in Schritt 1) erhaltenen Dispersion auf den porösen Filter ausgeführt wird.

8. Verfahren nach Anspruch 7, wobei der poröse Filter eine anodisierte Aluminiumoxid(AAO)-Membran ist.

9. Verfahren nach einem der vorstehenden Ansprüche, wobei das Trocknen aus Schritt 3) durch Wärmebehandlung der in Schritt 2) erhaltenen Anordnung bei einer Temperatur im Bereich von 60 bis 90 °C und für einen Zeitraum, der von 5 bis 30 Minuten variiert, in Luft durchgeführt wird.

10. Verfahren nach Anspruch 8 oder 9, wobei der vierte Schritt des Trennens des Silbernanodrähtefilms von dem Substrat durch Auflösen des Substrats der in Schritt 3) erhaltenen getrockneten Anordnung in einem auflösenden Medium durchgeführt wird.

11. Direkt durch das Verfahren nach einem der vorstehenden Ansprüche erhaltener transparenter und leitfähiger selbstgeträgerter Silbernanodrähtefilm, wobei der Film ein Netz aus perkolierten Silbernanodrähten umfasst und wobei die Oberfläche der Silbernanodrähte mit einer oxidationsbeständigen Schicht beschichtet ist, umfassend Triphenylphosphin oder ein Derivat davon, wobei das Derivat ausgewählt ist unter Bis(2,4-dimethoxyphenyl)phenylphosphin, (Methylphenyl)diphenylphosphin und 1,2-Bis(diphenylphosphino) ethan.

12. Film nach Anspruch 11, wobei der Film eine Dicke im Bereich von 10 bis 300 nm aufweist.

13. Verwendung eines direkt durch das Verfahren nach einem der Ansprüche 1 bis 10 erhaltenen oder wie in Anspruch 11 oder 12 definierten selbstgeträgerten Silbernanodrähtefilms als eine transparente und flexible Elektrode in einer elektrischen Vorrichtung.

14. Verwendung nach Anspruch 13, wobei der selbstgeträgerte Silbernanodrähtefilm als eine transparente und flexible Elektrode in einer Photovoltaikzelle, in Plasmabildschirmen, in Flüssigkristallanzeigen, in Touchscreens oder in organischen lichtemittierenden Vorrichtungen verwendet wird.

15. Elektrische Vorrichtung, umfassend mindestens einen direkt durch das Verfahren nach einem der Ansprüche 1 bis 10 erhaltenen oder wie in Anspruch 11 oder 12 definierten selbstgeträgerten Silbernanodrähtefilm als eine transparente und flexible Elektrode.

## Revendications

1. Procédé de production d'un film de nanofils d'argent auto-supporté transparent et conducteur, ledit procédé comprenant au moins les étapes suivantes :
1) une première étape de préparation d'une dispersion de nanofils d'argent dans un milieu liquide comprenant au moins un solvant et de la triphényl-phosphine (TPP) ou un dérivé de celle-ci, ledit dérivé étant choisi parmi la bis(2,4-diméthoxyphényl)phényl-phosphine, la (méthylphényl)diphénylphosphine et le 1,2-bis(diphénylphosphino)éthane,
2) une deuxième étape de dépôt de la dispersion obtenue dans l'étape 1) sur un substrat pour obtenir un assemblage comprenant un film de nanofils d'argent supporté sur ledit substrat,
3) une troisième étape de séchage de l'assemblage obtenu dans l'étape 2) pour obtenir un assemblage sec,
4) une quatrième étape de séparation du film de nanofils d'argent à partir du substrat de l'assemblage sec obtenu dans l'étape 3) pour obtenir un film de nanofils d'argent auto-supporté transparent et conducteur.

2. Procédé selon la revendication 1, dans lequel les nanofils d'argent utilisés selon l'étape 1) sont choisis parmi ceux ayant un diamètre moyen de 5 à 200 nm et une longueur de 1 à 100 µm.

3. Procédé selon la revendication 1 ou 2, dans lequel le milieu liquide utilisé pour disperser les nanofils d'argent pendant l'étape 1) est choisi parmi l'eau, l'alcool isopropylique, l'éthylène glycol et une résine époxy.

4. Procédé selon l'une quelconque des revendications précédentes, dans lequel la quantité de nanofils d'argent dans la dispersion de l'étape 1) varie de 0,1 à 4 mg.mL⁻¹.

5. Procédé selon l'une quelconque des revendications précédentes, dans lequel la quantité de diphénylphosphine dans la dispersion de l'étape 1) varie de 0,05 à 2 mg.mL⁻¹.

6. Procédé selon l'une quelconque des revendications précédentes, dans lequel le rapport en poids entre les nanofils d'argent et la TPP varie d'environ 2 : 1 à 1 : 2.

7. Procédé selon l'une quelconque des revendications précédentes, dans lequel le substrat est un filtre poreux et l'étape 2) est réalisée par la filtration de la dispersion obtenue dans l'étape 1) sur ledit filtre poreux.

8. Procédé selon la revendication 7, dans lequel le filtre poreux est une membrane d'oxyde d'aluminium anodisé (AAO).

9. Procédé selon l'une quelconque des revendications précédentes, dans lequel le séchage de l'étape 3) est réalisé par le traitement thermique de l'assemblage obtenu dans l'étape 2) à l'air, à une température de 60 à 90 °C, et pendant une période de temps variant de 5 à 30 minutes.

10. Procédé selon la revendication 8 ou 9, dans lequel la quatrième étape de séparation du film de nanofils d'argent à partir du substrat est réalisée par la dissolution du substrat de l'assemblage sec obtenu dans l'étape 3) dans un milieu de dissolution.

11. Film de nanofils d'argent auto-supporté transparent et conducteur obtenu directement par le procédé selon l'une quelconque des revendications précédentes, dans lequel ledit film comprend une toile de nanofils d'argent percolés, et dans lequel la surface desdits nanofils est revêtue d'une couche résistant à l'oxydation comprenant de la triphényl-phosphine ou un dérivé de celle-ci, ledit dérivé étant choisi parmi la bis(2,4-diméthoxyphényl)phénylphosphine, la (méthylphényl)diphénylphosphine et le 1,2-bis-(diphénylphosphino) éthane.

12. Film selon la revendication 11, dans lequel ledit film présente une épaisseur de 10 à 300 nm.

13. Utilisation d'un film de nanofils d'argent auto-supporté obtenu directement par le procédé selon l'une quelconque des revendications 1 à 10 ou tel que défini dans la revendication 11 ou 12, comme électrode transparente et flexible dans un dispositif électrique.

14. Utilisation selon la revendication 13, dans laquelle ledit film de nanofils d'argent auto-supporté est utilisé comme électrode transparente et flexible dans une cellule photovoltaïque, dans des écrans à plasma, dans des affichages à cristaux liquides, dans des écrans tactiles, ou dans des dispositifs organiques électroluminescents.

15. Dispositif électrique comprenant au moins un film de nanofils d'argent auto-supporté obtenu directement par le procédé selon l'une quelconque des revendications 1 à 10 ou tel que défini dans la revendication 11 ou 12, en tant qu'électrode transparente et flexible.
